(19)

Europäisches
Patentamt
European
Patent Office
Office européen
des brevets

(11) **EP 4 403 941 A2**

(12) **EUROPEAN PATENT APPLICATION**

(43) Date of publication:
**24.07.2024 Bulletin 2024/30**

(21) Application number: **23216709.8**

(22) Date of filing: **14.12.2023**

(51) International Patent Classification (IPC):
**G01R 31/367** (2019.01)     **G01R 31/392** (2019.01)
**H01M 10/42** (2006.01)

(52) Cooperative Patent Classification (CPC):
**H01M 10/42; G01R 31/367; G01R 31/392;**
H01M 10/4207

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.01.2023   KR 20230009023**

(71) Applicants:
• **Samsung SDI Co., Ltd.**
  **Yongin-si, Gyeonggi-do 17084 (KR)**
• **POSTECH Research and Business Development
  Foundation
  Pohang-si, Gyeongsangbuk-do (KR)**

(72) Inventors:
• **Lee, Gyeonghwan
  17084 Yongin-si, Gyeonggi-do (KR)**
• **Kim, Kwangrae
  Gyeongsangbuk-do (KR)**
• **Han, Soohee
  Gyeongsangbuk-do (KR)**
• **Kim, Minho
  Gyeongsangbuk-do (KR)**

(74) Representative: **Gulde & Partner
Patent- und Rechtsanwaltskanzlei mbB
Wallstraße 58/59
10179 Berlin (DE)**

(54)     **METHOD OF PREDICTING CAPACITY CHANGE IN BATTERY**

(57)     A method of predicting a capacity change of a battery includes calculating damage to cathode particles of a secondary battery during each charging/discharging cycle if the charging/discharging cycle is repeatedly performed in the secondary battery, calculating accumulated damage by accumulating the damage, calculating a minimum radius of the cathode particles in which a fatigue fracture occurs due to the accumulated damage, calculating, based on a distribution of radii of the cathode particles and the minimum radius, a reduction amount in a volume of a cathode active particle due to the fatigue fracture during each charging/discharging cycle, and calculating a relative capacity loss at a cathode based on the reduction amount in the volume of the cathode active particle during each charging/discharging cycle.

FIG. 1B

EP 4 403 941 A2

**Description**

CROSS-REFERENCE TO RELATED APPLICATION

BACKGROUND

1. Field

One or more embodiments relate to a method of predicting a change in a capacity of a battery, and more particularly, to a method of predicting a capacity change and a knee point according to charging/discharging cycles and degradation condition of a lithium-ion secondary battery.

2. Description of the Related Art

Lithium-ion secondary batteries, from among batteries mainly containing lithium, are rechargeable batteries. The main advantages of the lithium-ion secondary batteries are high energy density, high power density, and wide voltage range. Recently, as electric vehicles (EV) using lithium-ion secondary batteries as an energy storage device have been actively distributed, a battery management system (BMS), which is a core technique in the field of EVs, has been in the spotlight. Also, as the development of new renewable energy sources has been accelerated, the importance of an energy storage system (ESS) for stably connecting a renewable energy source to a power system has increased. Accordingly, the importance of related techniques for safely and efficiently managing and using a lithium-ion secondary battery has increased.

In a lithium-ion secondary battery, the internal resistance increases and the capacity decreases while charging and discharging are repeatedly performed. This is referred to as aging of the battery. An aging degree at a current point in time based on an initial state of a battery, e.g., a state after formation processes, is defined as an index referred to as a state of health (SOH) of a battery, and the SOH is generally defined based on a current capacity of the battery relative to an initial capacity of the battery. The initial capacity state of a battery is defined as a state in which the SOH is 100% or at a beginning of life (BOL), and about 80% with respect to the initial capacity is defined as SOH 80% or an end of life (EOL). In the case of an internal resistance, a measured value varies depending on an applied input and a temperature condition, and as aging progresses, a change in the internal resistance is relatively irregular as compared with the capacity change. Thus, the internal resistance is generally used as an auxiliary indicator for aging prediction.

If the capacity greatly decreases as the battery is aging, a significant issue may occur in the operation and safety of devices using the battery. First, if the capacity of the battery decreases, available time of a device using the battery is reduced, which may cause inconvenience to a user. Also, aging of the battery may act as a main cause of large accidents, such as an internal short-circuit of a battery or a thermal runaway. Therefore, replacing a battery if the SOH decreases by a certain amount through continuous monitoring of the SOH of the battery is recommend for using the battery economically and safely.

In particular, secondary use of a battery has been highlighted in view of environmental and economical aspects. Secondary use denotes reuse of a battery that is primarily used in an EV requiring high capacity and high output and reaches EOL in devices that are relatively stationary, have low output, and require a plurality of batteries. BOL and EOL described above are concepts defined in the primary use of the battery, and the battery may be actually used after the EOL, that is, at 80% or less of the initial capacity. However, the secondary use of the battery may not be possible according to a usage condition in the past. For example, a battery that has been used in harsh conditions may not be secondarily used after the EOL because a rapid decrease of the capacity after EOL may occur. Therefore, a process for determining whether the secondary use is possible with respect to batteries reaching the EOL in the primary use is performed, and after that, only the batteries that are guaranteed to be safe to use are secondarily used. The most important factor in the process of verifying the secondary usability is prediction of degradation pattern of a battery after EOL, that is, 80% or less of the initial capacity.

The degradation pattern after EOL is different from that before EOL. An example includes a "knee point" effect, in which the capacity rapidly decreases after EOL. The knee point generally occurs after the EOL, and whether the effect is generated and a point where the effect occurs vary depending on managing environment and condition of the battery. The knee point generally occurs earlier when, for example, a battery is used under harsh conditions such as high rate charging/discharging, operation in a temperature range other than room temperature, charging/discharging beyond a manufacturer recommended voltage range. A battery in which the knee point occurs or is expected to occur in the near future may cause inconvenience, economic loss, and safety issues during use. Thus, a battery inspector has to predict this matter and provide the user with related information in advance. Also, a battery that is not possible to be secondarily used has to be screened in advance in the process of verifying secondary usability. Therefore, in order to use a battery safely and economically in the entire lifespan thereof, a capacity fade model is necessary, wherein the capacity fade model is capable of comprehensively predicting a degradation pattern after EOL and the appearance of the knee point, as well as the degradation pattern from the BOL to EOL.

A capacity fade model according to the related art may be classified in three kinds, that is, an empirical model, a physical-based model, and a data-driven model.

The empirical model represents data from a battery by using a specific empirical model expression. The empirical principles may be used are as follows: the first is that capacity variations follow a power law with respect to the number of charging/discharging cycles; the second is that capacity variations are expressed as a function of the current throughput of a battery; and the third is that the influence of temperature on capacity variations follows the Arrhenius law. Most empirical models are simple mathematical models based on the above-mentioned principles, and may not require a high-performance processor owing to a small amount of calculation. Even in the case of empirical models, countless models may be possible according to combinations of the principles, and there is no standardized empirical model that has been proven to be accurate. In addition, with the above-mentioned principles, it may be difficult to express actual electrochemical phenomena occurring in the battery, and empirical modes may result in large errors if used under certain physical properties or environments.

The physical-based model is a method of using a model for predicting aging progresses according to usage patterns by modeling electrochemical phenomena inside a battery into various physical parameters and several partial differential equations. Most physical-based models are universal models for predicting aging patterns if arbitrary inputs are applied to batteries. However, this method requires accurate knowledge of numerous physical parameter values inside batteries for the accuracy of prediction. However, actually, this is nearly impossible. It is possible to obtain some parameter values during battery production, but it may be extremely complicated, time-consuming, or sometimes impossible to obtain accurate values for all parameters. In addition, modeled phenomena may not reflect the full complexity inside batteries, and thus, there is no standardized physical-based model reflecting all phenomena related to the aging of a battery. Also, the physical-based model may require a long calculation time because complicated partial differential equations have to be solved, and it is difficult to apply the physical-based model to a device requiring real-time calculation. Also, a high-performance processor is necessary for calculation, and costs for establishing hardware increase.

The data-driven model is a method of predicting capacity variation by training a machine learning model using data obtained through battery experiments. This method makes it possible to reflect all the various physical characteristics of batteries and to create a prediction model capable of predicting capacity variations with respect to arbitrary inputs. A drawback of data-driven models is that it may be difficult to perform accurate predictions if data is insufficient. It may not be easy to obtain a large amount of data about batteries. Battery experiments require a lot of effort, including long hours, expensive equipment, and the need to keep many environmental conditions constant, and thus, it is impossible to obtain a lot of data in a short period of time under a variety of conditions. Therefore, a data-driven model is not a practical model at this point in time.

Therefore, in order to predict the degradation of batteries in actual sites and products, it is necessary to develop a capacity fade model that may reflect the physical characteristics of various types of batteries, requires less computation, may be built with relatively little data, is reliable in prediction, and has high accuracy.

In addition, many existing models may only predict if the SOH reaches 80%, and may not predict the pattern in the middle of degradation from 100% to 80% of SOH. In addition, even if there are models that determine the SOH in the middle of degradation, most of the models target BOL to EOL, and there are few models that predict the degradation pattern after EOL and the expression of knee point.

SUMMARY

The present invention is set out in the appended set of claims, wherein the drawings and respective description relate to advantageous embodiments thereof. It was an object of the present invention to provide a method of predicting the degradation of batteries in actual sites and products which requires less computation, may be built with relatively little data, is reliable in prediction, and has high accuracy. Moreover, it was an object of the present invention to provide a capacity fade model, which is capable of comprehensively predicting a degradation pattern after EOL and the appearance of the knee point, as well as the degradation pattern from the BOL to EOL.

The present invention is directed to a method of predicting a capacity change of a battery, including calculating damage to cathode particles of a secondary battery during each charging/discharging cycle if the charging/discharging cycle is repeatedly performed in the secondary battery, calculating accumulated damage by accumulating the damage, calculating a minimum radius of the cathode particles in which a fatigue fracture occurs due to the accumulated damage, calculating, based on a distribution of radii of the cathode particles and the minimum radius, a reduction amount in a volume of a cathode active particle due to the fatigue fracture during each charging/discharging cycle, and calculating a relative capacity loss at a cathode based on the reduction amount in the volume of the cathode active particle during each charging/discharging cycle.

In embodiments, the cathode particles are spherical solid particles, and a lithium concentration is radial symmetry.

In embodiments, the accumulated damage is a fatigue damage D that is accumulated on the cathode particle surfaces.

In embodiments, the calculating of the damage to the cathode particles during each charging/discharging cycle includes calculating an effective stress applied to the cathode particles based on a magnitude of a charging current in each charging/discharging cycle, calculating a stress range applied to the cathode particles based on the effective stress, and calculating the damage corresponding to the stress range, based on a relationship between a magnitude of the stress range and a number of charging/discharging cycles at which the fatigue fracture occurs.

In embodiments, the damage of the stress in each charging/discharging cycle contributing to fatigue fracture is calculated by applying Palmgren-Miner's rule.

In embodiments, the capacity loss is expressed as a capacity loss relative to an initial capacity CapBOL, RCL, wherein RCL is defined by Equation 1,

$$RCL(t) = \frac{Cap_{BOL} - Cap(t)}{Cap_{BOL}}$$
$$RCL_n = \frac{Cap_{BOL} - Cap_n}{Cap_{BOL}}$$

[Equation 1]

wherein RCL(t) denotes an RCL at a time t, CapBOL denotes a capacity at the initial state, and Cap(t) denotes a capacity at time t. RCLn denotes the RCL after n aging cycles are performed from the initial state, and Capn denotes a capacity after n aging cycles are performed from the initial state and wherein the relative capacity loss RCLn after performing n aging cycles from the initial state is expressed is expressed as a sum of an RCL after performing (n-1) aging cycles from the initial state, capacity loss ΔRCLn+ due to the degradation at the cathode according to the n-th aging cycle, and the capacity loss ΔRCLn-due to the degradation at the negative electrode according to the n-th aging cycle according to Equation 2,

$$RCL_n = RCL_{n-1} + \Delta RCL_n^+ + \Delta RCL_n^-$$

[Equation 2].In embodiments, the stress range S is calculated based on the S-N curve expression proposed by Stromeyer according to Equation 3,

$$n_{\text{frac}}(S) = \exp(\beta_0 + \beta_1 \ln(S - \sigma_{\lim})) \qquad for \ S > \sigma_{\lim}$$

[Equation 3]

wherein $\beta_0$ and $\beta_1$ are preset tuning parameters, and $\sigma_{\lim}$ is the minimum value of stress that may cause fatigue fracture.

In embodiments, the method of predicting a capacity change of a battery, further includes calculating a relative capacity loss in an anode during each charging/discharging cycle by using an aging density function (ADF) model, and calculating a current state capacity loss of the secondary battery in which a current charging/discharging cycle is performed by adding all of a previous relative capacity loss of the secondary battery calculated in a previous charging/discharging cycle, the relative capacity loss in the cathode, and the relative capacity loss in the anode.

Embodiments are also directed to a method of predicting a capacity change of a battery, the method including obtaining experimental data by repeatedly performing a charging/discharging cycle of a secondary battery, optimizing an inhomogeneous stress-induced fracture (ISIF) model by using the experimental data, generating virtual data by using the optimized ISIF model, training an artificial neural network by using the experimental data and the virtual data, and predicting, by using the artificial neural network, a capacity variation of the secondary battery in which the charging/discharging cycle is repeatedly performed under a preset condition.

In embodiments, the artificial neural network is a Bayesian neural network (BNN) using actual data and virtual data.

In embodiments, the charging/discharging cycle of the secondary battery icludes a constant current charging section in which the secondary battery is charged with a constant current of a charging current value, a constant voltage charging section in which the secondary battery is charged with a constant voltage of a charging voltage value if the charging voltage of the secondary battery reaches a first cut-off voltage, a first rest section in which the charging of the secondary battery is stopped for a first rest time if the charging current of the secondary battery reaches a cut-off current, a constant current discharge section in which the secondary battery is discharged with a constant current of a discharge current value, and a second rest section in which the discharging of the secondary battery is stopped during a second rest time if the discharge voltage of the secondary battery reaches a second cut-off voltage.

In embodiments, the obtaining of the experimental data includes repeatedly performing the charging/discharging cycle on the secondary battery, wherein, in the charging/discharging cycle, at least one the charging current value, the charging voltage value, the discharging current value, the first cut-off voltage, the cut-off current, the second cut-off voltage, the first rest time, and the second rest time is set differently.

One or more embodiments include a method of predicting battery capacity, which is capable of predicting capacity change according to the number of charging/discharging cycles during a total lifespan period of a lithium-ion secondary battery, and in particular, predicting a degradation pattern of the lithium-ion secondary battery after end of life (EOL) and expression of a knee point.

Additional aspects will be set forth in part in the description which follows and, in part, will be apparent from the description, or may be learned by practice of the presented embodiments of the disclosure.

BRIEF DESCRIPTION OF THE DRAWINGS

Features will become apparent to those of skill in the art by describing in detail exemplary embodiments with reference to the attached drawings, in which:

FIG. 1A is a diagram showing repeated application of cyclic stress having a stress range of $S_n$ to cathode particles;
FIG. 1B is a diagram showing an S-N curve representing a relationship between a cyclic stress repeatedly applied to cathode particles and the number of cycles at which fatigue fracture occurs if a stress range is $S_n$;
FIG. 2A is a diagram showing a tensile stress and compressive stress applied to surfaces of cathode particles, and a crack propagation due to the tensile stress;
FIG. 2B is a diagram showing a charging/discharging current profile in a charging/discharging cycle;
FIG. 2C is a diagram showing an effective stress applied to cathode particles in the charging/discharging current profile of FIG. 2B;
FIG. 2D is a diagram showing that the stress range $S_n$ gradually increases if fatigue fracture occurs due to repeated charging/discharging cycles, that is, due to active material loss (AML);
FIGS. 3A and 3B are diagrams showing that the stress range $S_n$ in FIG. 2D may be changed to the stress range $S_n$ in FIG. 3B;
FIG. 3C is a diagram showing the number of cycles $n_{frac}$ at which the fatigue fracture occurs according to the stress range $S_n$ shown in FIG. 3B;
FIG. 4A is a diagram showing a distribution of radiuses of the cathode particles;
FIG. 4B is a diagram showing a change in an accumulated damage $D_n(R)$ according to the charging/discharging cycles progress, and a change in a total surface area $A_{act,n}$ of cathode active particles in an n-th cycle therefrom; and
FIG. 5 is a diagram showing a visualization of an aging density function (ADF).

DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

The terms used herein are only for explaining certain embodiments, and are not used to limit the present disclosure to the dictionary meaning of the term. It will be further understood that if a portion is referred to as "comprising" another component, the portion may not exclude another component but may further comprise another component unless the context states otherwise.

A method of predicting capacity variation according to embodiments may include two main processes. A first process is a process of optimizing parameters of inhomogeneous stress-induced fracture (ISIF) model by using charging/discharging cycle experiment data of a battery, and a second process is a process of generating virtual data using the optimized ISIF model and training a Bayesian neural network (BNN) using actual data and virtual data to utilize the BNN for capacity variation prediction.

The first process includes a process of degradation pattern data according to charging/discharging cycles of a battery. The degradation pattern data of the battery is data representing a change in condition if a test profile assuming that the battery is in use is applied to the battery and obtained through a sensor. In general, a test profile includes an aging cycle to simulate degradation and a reference performance test (RPT) that includes a process of periodically measuring the internal state of the battery as changes occur with degradation.

The various charge and discharge conditions that change the degradation pattern of a battery are defined as aging cycle conditions (ACC). The ACC may include, e.g., a charging current value, a charging voltage value, a discharging current value, maximum and minimum voltage values during charging and discharging, and a duration of rest time. A charging/discharging cycle that is carried out to confirm degradation in a particular ACC is defined as an aging cycle. In the present specification, one charging/discharging cycle is defined as a series of processes proceeding to a charging section, a rest section for a preset time, a discharging section, and a rest section for a preset time. During the charging section, a constant current (CC) charging and a constant voltage (CV) charging may be performed. During the rest section, the battery may rest, e.g., for 10 minutes. During the discharging section, a CC discharge may be performed.

After repeatedly performing the aging cycle for a preset number of times, a RPT is performed to measure the changing status of battery. The RPT is a test process that is periodically performed every preset number of charging/discharging cycles in order to measure the change in the battery under the same condition. For example, the aging cycles are repeated 80 times, and the RPT is performed, after that, the aging cycles are repeated 80 times, and then, the RPT may be performed. The states of the battery measured through the RPT may representatively include a capacity (mAh) of the battery. The CC-CV charging and CC discharging are performed at a preset C-rate (e.g., set as a lower value) and a preset depth of discharge (DOD), and then currents during the discharging are accumulated to measure the capacity (mAh) of the battery. The C-rate may be set in advance to be a fixed low value, and the DOD may be set in advance as 100%.

Various parameters representing the status of the battery, e.g., direct current internal resistance (DCIR), may be measured by adding additional processes to the RPT. Also, an open circuit voltage (OCV)-state of charge (SOC) lookup table may be obtained by performing discharging experiments with a constant current of 0.01 C-rate or less. The parameters of an ISIF model may be optimized by using battery data obtained through the aging cycle and the RPT.

ISIF model

The ISIF model according to the disclosure considers lithium inventory loss (LIL) and LIL caused due to active material loss (AML) as capacity reduction factors of a lithium-ion battery. Film formation in an anode particle, including a solid electrolyte interphase (SEI) layer formation and lithium plating, and the LIL are modeled as an empirical model. A phenomenon in which fatigue fracture occurs in the cathode particle due to mechanical stress and an AML occurs, and then the capacity reduced due to the LIL caused by the AML is modeled as a physical-based model.

Relative capacity loss (RCL) of an ISIF model

In the ISIF model, the capacity loss may be expressed as a capacity loss relative to an initial capacity $Cap_{BOL}$, i.e., an RCL. RCL may be defined by Equation 1 below.

[Equation 1]

$$RCL(t) = \frac{Cap_{BOL} - Cap(t)}{Cap_{BOL}}$$

$$RCL_n = \frac{Cap_{BOL} - Cap_n}{Cap_{BOL}}$$

In Equation 1, RCL(t) denotes an RCL at a time t, $Cap_{BOL}$ denotes a capacity at the initial state, and Cap(t) denotes a capacity at time t. $RCL_n$ denotes the RCL after n aging cycles are performed from the initial state, and $Cap_n$ denotes a capacity after n aging cycles are performed from the initial state.

In the ISIF model, the relative capacity loss $RCL_n$ after performing n aging cycles from the initial state may be expressed by Equation 2 below.

[Equation 2]

$$RCL_n = RCL_{n-1} + \Delta RCL_n^+ + \Delta RCL_n^-$$

The relative capacity loss $RCL_n$ after performing n aging cycles from the initial state may be expressed as a sum of an RCL after performing (n-1) aging cycles from the initial state, capacity loss $\Delta RCL_n^+$ due to the degradation at the cathode according to the n-th aging cycle, and the capacity loss $\Delta RCL_n^-$ due to the degradation at the negative electrode according to the n-th aging cycle.

Capacity loss amount due to degradation at the cathode $\Delta RCL_n^+$

As the charging/discharging cycles progress, mechanical stress occurs due to deintercalation and intercalation on the particle surface of the electrode. The repeated mechanical stress causes the fatigue fracture of the electrode particle. The electrode particle in which the fatigue fracture occurs is electrically inactivated and may not further participate in the deintercalation and intercalation, that is, a particle isolation occurs. The above phenomenon is referred to as AML. Lithium in the electrode particle that is inactivated is also inactivated, and accordingly, the capacity loss occurs. The above capacity loss also corresponds to LIL.

In general, the AML occurring on the cathode due to the charging/discharging is an important degradation. On the contrary, the AML caused due to the charging/discharging in the anode is not greater as compared with the cathode, and is considered as a minor degradation. In the disclosure, the AML in the anode is not considered, and the LIL caused due to the AML in the cathode is modeled as a major capacity loss factor.

As the charging/discharging cycle progresses, the physical damage due to the charging/discharging of the battery may be accumulated on the cathode particle surface, and if the physical damage exceeds a certain damage threshold, the fatigue fracture occurs in the cathode particle. The ISIF model of the disclosure models the above phenomenon. The capacity loss due to the AML generated by the fatigue fracture and the LIL caused therefrom is defined as the capacity loss $\Delta RCL_n^+$ due to the degradation at the cathode according to the n-th aging cycle.

S-N curve and Fatigue stress damage ($\Delta D_{fg}$)

The S-N curve shows the relationship between the stress range S of cyclic stress repeatedly applied to a solid material, such as a cathode solid particle, and the number of cycles N in which the cyclic stress causes a fatigue fracture in the solid material. The stress range S is defined as a difference between the maximum stress $\sigma_{max}$ and minimum stress $\sigma_{min}$ in a single cycle.

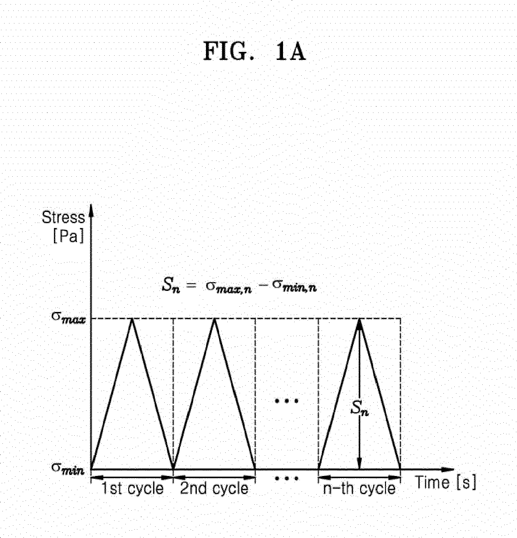

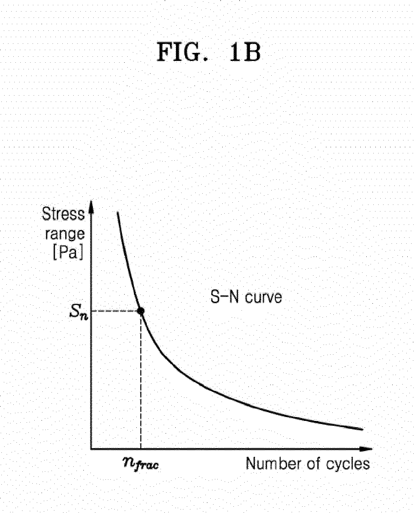

The ISIF model of the disclosure models that for each repeated charging/discharging cycle of the battery, a cyclic stress with the stress range S as shown in the graph of FIG. 1A is repeatedly applied to the cathode particles, and that the number of cycles $n_{frac}$ in which fatigue fracture occurs follows an S-N curve as shown in the graph of FIG. 1B for the stress range S. In the disclosure, the number of cycles at which fatigue fracture occurs $n_{frac}$ with respect to the stress range S is expressed as Equation 3 below based on the S-N curve expression proposed by Stromeyer.

[Equation 3]

$$n_{\text{frac}}(S) = \exp(\beta_0 + \beta_1 \ln(S - \sigma_{\text{lim}})) \qquad for\ S > \sigma_{\text{lim}}$$

In Equation 3, $\beta_0$ and $\beta_1$ are preset tuning parameters, and $\sigma_{lim}$ is the minimum value of stress that may cause fatigue fracture. A function $n_{frac}(S)$ of the number of cycles $n_{frac}$ at which the fatigue fracture occurs with respect to the stress range S is a monotonically decreasing function.

According to the disclosure, in an environment where the stress range S of the cyclic stress applied to a particle changes as the charging/discharging cycles are repeated, damage of the stress in each charging/discharging cycle contributing to fatigue fracture can be calculated by applying Palmgren-Miner's rule. Here, by using Equation 3 above, the $n_{frac}(S_n)$ corresponding to the n-th stress range $S_n$ may be calculated, and the damage to the cathode particles due to cyclic stress may be defined. If the cyclic stress with the stress range of S is repeated $n_{frac}$ times and fatigue fracture occurs on the surface of the cathode particle, the damage fraction $\Delta D_{fg}$, which is the damage to the cathode particle by the cyclic stress during one cycle, is $1/n_{frac}$. Therefore, if the stress with the n-th stress range of $S_n$ is applied to the cathode particle, the resulting damage fraction $\Delta D_{fg,n}$ in the n-th cycle may be expressed as Equation 4 below.

[Equation 4]

$$\Delta D_{\mathrm{fg},n} = \frac{1}{n_{\mathrm{frac}}(S_n)} = \frac{1}{\exp(\beta_0 + \beta_1 \, ln(S_n - \sigma_{\mathrm{lim}}))}$$

According to Palmgren-Miner's rule, the total damage $D_{\mathrm{fg,N}}$ accumulated from the first cycle to the N-th cycle is the sum of the damage fractions $\Delta D_{\mathrm{fg,N}}$ in Equation 4, which may be expressed by Equation 5 below.

[Equation 5]

$$D_{\mathrm{fg},N} = \sum_{n=1}^{N} \Delta D_{\mathrm{fg},n} = \sum_{n=1}^{N} \frac{1}{n_{\mathrm{frac}}(S_n)}$$

Stress range $S_n(R)$ of the cyclic stress applied to the cathode particle

To calculate the fatigue stress damage to the cathode particles during the charging/discharging, stress $\sigma(R,t)$ [pa] applied periodically to a particle with radius R at time t may be calculated. In an embodiment, the damage to cathode particles of a secondary battery during each charging/discharging cycle may be calculated if the charging/discharging cycle is repeatedly performed in the secondary battery.

As it is in typical electrochemical battery models, it is assumed that the solid particles are spherical, and a lithium concentration is radial symmetry. Solid particle refers to the cathode particle. Solid particles may refer to both cathode and anode particles.

At time t, the lithium concentration $c_s{}^+$ [mol/m³] may be approximated in a quadratic form as in Equation 6 below at a position separated by $\eta$ from a center of the particle, that is, at a position where the radial distance from the center of the particle is $\eta$. Here, a superscript + in $c_s{}^+$ refers to the concentration of lithium in the particle.

[Equation 6]

$$c_s^+(\eta, t) = \alpha_1(t) \cdot \eta^2 + \alpha_2(t) \cdot \eta + \alpha_3(t)$$

By FICC 's law and mass conservation, the following boundary conditions have to be satisfied.

The first boundary condition is that a gradient of the lithium concentration at the center of the particle, i.e., at $\eta=0$, is zero. This is expressed by Equation 7 below.

[Equation 7]

$$\kappa_s^+ \left. \frac{\partial c_s^+(\eta, t)}{\partial \eta} \right|_{\eta=0} = 0$$

In Equation 7, $c_s{}^+$ is a lithium concentration [mol/m³] in the particle, and $\kappa_s{}^+$ is a diffusion coefficient [m²/sec] of lithium in the particle.

The second boundary condition is that a gradient of lithium concentration at the surface of a single cathode particle, i.e., at $\eta=R$, has the relationship shown in Equation 8 below according to Fick's law (i.e., Fick's first law).

[Equation 8]

$$\kappa_s^+ \left. \frac{\partial c_s^+(\eta, t)}{\partial \eta} \right|_{\eta=R} = -J^+(t)$$

In Equation 8, $-J^+(t)$ is a molar flux density of lithium entering the particle from the surface of the particle (i.e., intercalation) by the discharge of the battery at time (t) [mol/sec·m²]. $J^+$ is defined as having a positive sign if lithium is exiting the particle from the inside to the outside, and a negative sign if lithium is entering the particle from the outside.

Here, the molar flux density $J^+(t)$ [mol/sec·m²] of lithium on the surface of the particle is defined by Equation 9 below.

[Equation 9]

$$J^+(t) = \frac{i(t)}{FL^+ a^+(t)}$$

In Equation 9, $i(t)$ is a current per unit cross section area [A/m² ] at time t, F is the Faraday constant [c +/mol], $a^+(t)$ is a specific interfacial area [m⁻¹] of the cathode electrode per unit volume at time t, and $L^+$ is the thickness [ m ] of the cathode electrode.

The third boundary condition is that there has to be mass conservation between inside and outside of the cathode particles by a continuity equation, which may be expressed as Equation 10 below.

[Equation 10]

$$\frac{\partial}{\partial t}\left( \int_0^R c_s^+(\eta, t) \cdot 4\pi\eta^2 d\eta \right) = -J^+(t) \cdot 4\pi R^2$$

The left side of Equation 10 above indicates a change in the total amount of lithium inside the particle, and the right side denotes the number of moles of lithium per hour, the lithium entering the inside through the surface of the cathode particle.

Equation 6 above for the lithium concentration (cs+) is differentiated with respect to $\eta$ and multiplied by κs+ on both sides, resulting in Equation 7 and Equation 8, and then may be expressed by Equation 11 below.

[Equation 11]

$$\kappa_s^+ \left. \frac{\partial c_s^+(\eta, t)}{\partial \eta} \right|_{\eta=0} = (2\alpha_1(t) \cdot 0 + \alpha_2(t))\kappa_s^+ = 0$$

$$\kappa_s^+ \left. \frac{\partial c_s^+(\eta, t)}{\partial \eta} \right|_{\eta=R} = (2\alpha_1(t) \cdot R + \alpha_2(t))\kappa_s^+ = -J^+(t)$$

$$\alpha_1(t) = -\frac{J^+(t)}{2R\kappa_s^+}$$

According to Equation 11 above, and $\alpha_2(t) = 0$ are deduced.

If Equation 10 above is solved by using the above result, Equation 12 below is obtained.

[Equation 12]

$$\left(\int_0^R c_s^+(\eta,t) \cdot \eta^2 d\eta\right) = \left(\int_0^R \frac{\partial \alpha_1(t)}{\partial t} r^4 + \frac{\partial \alpha_3(t)}{\partial t} \eta^2 d\eta\right) = -J^+(t) \cdot R^2$$

$$\Leftrightarrow \frac{1}{3}\left(\frac{\partial \alpha_1(t)}{\partial t} R^2 + \frac{\partial \alpha_3(t)}{\partial t}\right) = -\frac{J^+(t)}{R} + \frac{2}{15}\frac{\partial \alpha_1(t)}{\partial t} R^2$$

$$\Leftrightarrow \frac{\partial c_s^+(R,t)}{\partial t} = -\frac{3}{R}J^+(t) - \frac{1}{5}\frac{R}{\kappa_s^+}\frac{\partial J^+(t)}{\partial t}$$

For calculating the stress that causes a crack in the surface of an isotropic material, stresses in the tangential direction are only used. The stress described below is the stress in the tangential direction.

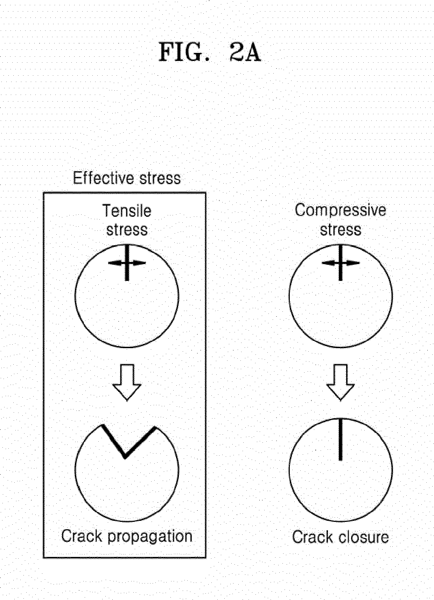

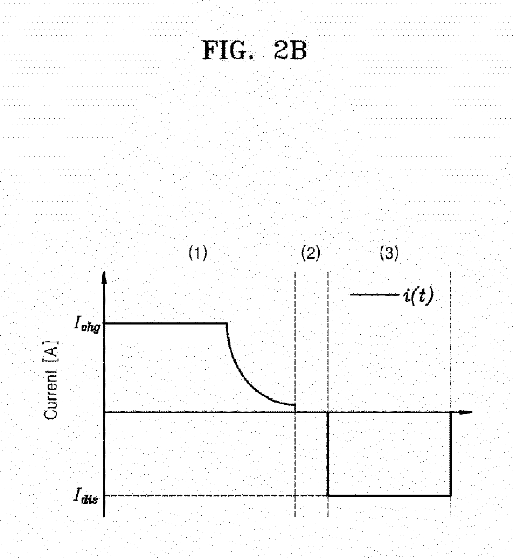

As shown in FIGS. 2A and 2B, the stress acting on the surface of the cathode particle to cause a crack may be classified as tensile stress, i.e., stress in the direction of opening the crack to the sides, and compressive stress, i.e., stress in the direction of closing the crack. The former is generated by the charging of the battery, that is, deintercalation in the cathode particle, and is expressed by + sign. Conversely, the latter is generated by the discharging of the battery, that is, intercalation in the cathode particles, and is expressed by - sign.

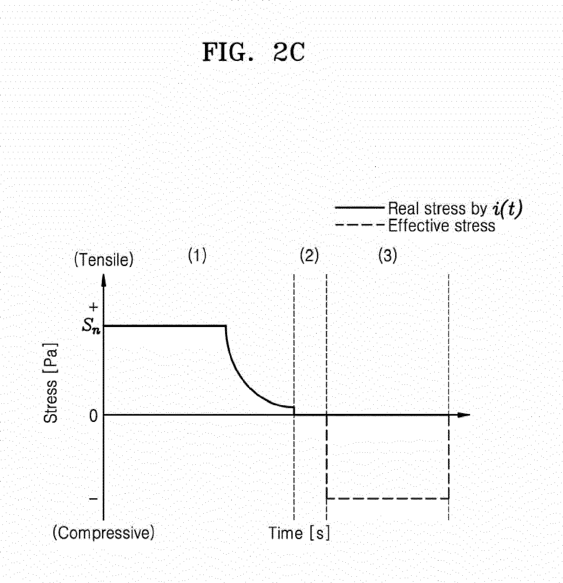

For calculating the damage caused by the stress that results in the crack due to the fatigue fracture on the surface of cathode particles, it is generally known that it is reasonable to ignore the effects of compressive stress and calculate only the damage caused by the tensile stress. This is because, if charging is performed as shown in FIG. 2A, the tensile stress acts on the surface of the cathode particles, and during the discharging, the compressive stress acts on the surface of the cathode particles, and the compressive stress does not act in a crack propagation direction. Accordingly, the compressive stress is generally considered to have no effect on crack generation. In the disclosure, only the damage caused by the tensile stress is considered for calculating the damage that causes a crack. Thus, in the ISIF model of the disclosure, if the effective stress actually applied on the cathode surface according to the charging/discharging process is represented in a graph, a red solid line as shown in FIG. 2C is obtained.

In an embodiment, the effective stress applied to the cathode particles may be calculated based on a magnitude of a charging current in each charging/discharging cycle. The stress range applied to the cathode particles based on the effective stress may be calculated. The damage corresponding to the stress range, based on a relationship between a magnitude of the stress range and a number of charging/discharging cycles at which the fatigue fracture occurs may be calculated.

The effective stress $\sigma(R,t)$ [pa] of the cyclic stress acting on the surface at the center of the cathode particle with radius R at time t may be calculated according to Equation 13 below.

[Equation 13]

$$\sigma(R,t) = \frac{\Omega E^+}{3(1-v^+)}\left(\frac{3}{R^3}\int_0^R c_s^+(\eta,t) \cdot \eta^2 d\eta - c_s^+(R,t)\right)$$

$$= \Phi\left(\frac{3}{R^3}\int_0^R c_s^+(\eta,t) \cdot \eta^2 d\eta - c_s^+(R,t)\right)$$

In Equation 13, $\Omega$ is a partial molar volume [m³/mol], $E^+$ is Young's modulus [GPa], $v^+$ is a Poisson's ratio, and

$$\Phi = \frac{\Omega E^+}{3(1-v^+)}$$

$\Phi$ is a constant of .

A volumetric average lithium concentration ($c_{s,avg}^+$ (R, t) [mol/m³]) with respect to a volume of articles having a radius of R is defined as

$$c^+_{S,\text{avg}}(R,t) = \frac{\int_0^R c_s^+(r,t) \cdot 4\pi r^2 dr}{\frac{4}{3}\pi R^3},$$

and using this, Equation 13 is re-arranged as shown in Equation 14 below.

[Equation 14]

$$\sigma(R,t) = \Phi\left(\frac{3}{R^3}\int_0^R c_s^+(\eta,t)\cdot\eta^2 d\eta - c_s^+(R,t)\right)$$

$$= \Phi\left(c^+_{S,avg}(R,t) - c_s^+(R,t)\right)$$

If Equation 12 and Equation 10 are integrated with respect to t and then substituted into Equation 14, a stress $\sigma(R,t)$ of the cyclic stress applied to the surface of the particle at time t may be calculated as shown in Equation 15 below. Here, it is assumed that $J^+(0) = 0$ in the initial state ($t = 0$, BOL, idle state, SOC < = 100%) of the battery, and $\Psi = \Phi\,(c_{s,\text{avg}}^+(R,0) - c_s^+(R,0))$ is a tuning parameter.

[Equation 15]

$$\sigma(R,t) = \Phi\left(c^+_{S,avg}(R,t) - c_s^+(R,t)\right)$$

$$= \Phi\left(c^+_{S,\text{avg}}(R,t) + \frac{3}{R}\int_0^t J^+(\tau)d\tau + \frac{R}{5\kappa_s^+}J^+(t) - c_s^+(R,0)\right)$$

$$= \Phi\left(c^+_{S,\text{avg}}(R,t) + \frac{1}{\frac{4}{3}\pi R^3}\int_0^t 4\pi R^2 \cdot J^+(\tau)\tau + \frac{R}{5\kappa_s^+}J^+(t) - c_s^+(R,0)\right)$$

$$= \Phi\left(c^+_{S,\text{avg}}(R,t) - \left(c^+_{S,\text{avg}}(R,t) - c^+_{S,\text{avg}}(R,0)\right) + \frac{R}{5\kappa_s^+}J^+(t) - c_s^+(R,0)\right)$$

$$= \Phi\cdot\frac{R}{5\kappa_s^+}J^+(t) + \Psi$$

In Equation 15, $J^+(0)=0$ and $\Psi=(\Phi\cdot c_{s,\text{avg}}^+(R,0)-c_s^+(R,0))$.
By using Equation 15 above, for a particle of radius R, if the n-th cycle starts at the initial time (t=0) and t is a point in time at which the maximum stress appears, a minimum value of stress at the n-the cycle is $\sigma_{\text{min},n}(R)=0$ and the maximum value is $\sigma_{\text{max},n}(R)$. The stress range $S_n(R)$ applied to the surface of the cathode particle having a radius R during the n-th cycle may be calculated, by definition, as shown in Equation 16 below.

[Equation 16]

$$S_n(R) = \sigma_{\max,n}(R) - \sigma_{\min,n}(R)$$

$$= \Phi \cdot \frac{R \cdot i_{\max,n}}{5\kappa_s^+ FL^+ \cdot a^+} + \Psi = K \cdot \frac{C_{\text{chg},n}}{A_{\text{act},n}} \cdot R + \Psi$$

In Equation 16, $A_{\text{act},n}$, $i_{\max,n}$, and K are defined as follows.

$$A_{\text{act},n} = a^+ \cdot L^+ \cdot A_{\text{cross},n}$$

$$i_{\max,n} = \frac{\text{Cap}_{\text{BOL}} \cdot C_{\text{chg},n}}{A_{\text{cross},n}}$$

$$K = \Phi \cdot \frac{\text{Cap}_{\text{BOL}}}{5\kappa_s^+ FL^+ \cdot a^+}$$

$\text{Cap}_{\text{BOL}}$ is the initial total capacity [A·hour] of the battery, $i_{\max,n}$ is a maximum current [A/m$^2$] per unit cross-sectional area at the n-th cycle, R is a radius [m] of the particle, $A_{\text{cross},n}$ is a total cross-sectional area [m$^2$] of the cathode active particle at the n-th cycle, $A_{\text{act},n}$ is a total surface area [m$^2$] of the cathode active particle at the n-th cycle, $C_{\text{chg},n}$ is a charging C-rate [hour$^{-1}$] at the n-th cycle, and K is a constant.

$A_{\text{cross},n}$ denotes a cross-sectional area of the electrode, and a volume of the electrode is expressed as $L^+ \cdot A_{\text{cross},n}$. $A_{\text{act},n}$ denotes a surface area of a spherical particle and may be expressed as $A_{\text{act},n} = L^+ \cdot A_{\text{cross},n} \cdot a^+$ that is a product of the volume ($L^+ \cdot A_{\text{cross},n}$) of the electrode and a surface area ($a^+$) of the spherical particle per unit volume.

In an embodiment, based on a distribution of radii of the cathode particles and the minimum radius, a reduction amount in a volume of a cathode active particle due to the fatigue fracture during each charging/discharging cycle may be calculated.

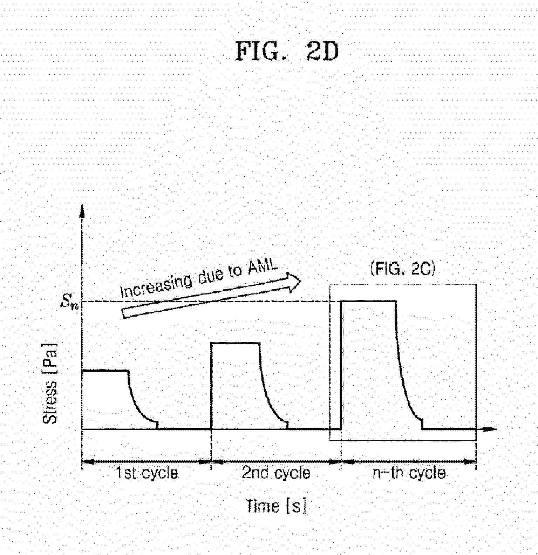

As the charging/discharging cycle progresses, the AML continuously occurs in the cathode, and accordingly, the total area and volume of the active particles may be reduced, and the stress applied to the cathode particles continuously changes as the charging/discharging cycle progresses. This may be expressed or shown as a graph as shown in FIG. 2D.

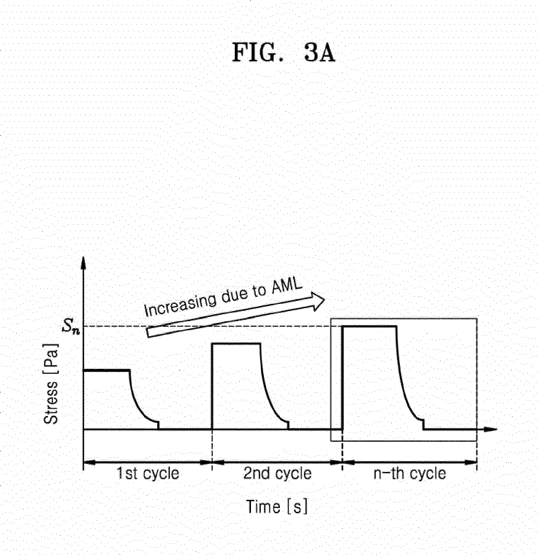

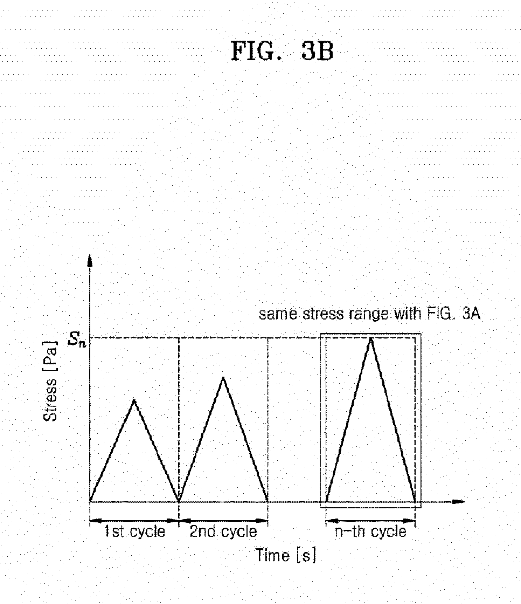

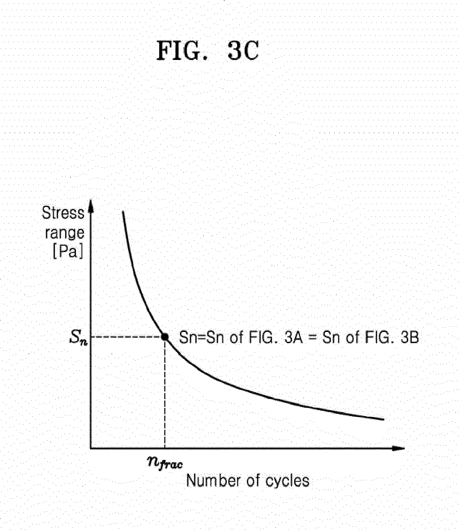

Even if the waveform of the stress acting on the material is different, the fatigue fracture damage to the material is the same provided that a maximum point and a minimum point of the waveform are the same. Therefore, the stress waveform shown in FIG. 3A generated by the charging/discharging cycle may be changed to the stress range $S_n$ shown in FIG. 3B. A damage fraction ($\Delta D_{\text{fg},n}(R)$) corresponding to the stress range $S_n(R)$ of the cyclic stress according to a cycle may be calculated by using the S-N curve as in Equation 17 below.

In the disclosure, $C_{\text{chg}}$ maintains the same value for the entire cycle in the same profile, that is, it is assumed that $C_{\text{chg},n} = C_{\text{chg}}$, and $A_{\text{act},n}$ continuously decreases from a point in time if the fatigue fracture of the particle occurs as the cycle progresses. Therefore, after the fatigue fracture of the cathode particles occurs, the size of the stress range $S_n$ increases continuously.

The fatigue fracture damage fraction $\Delta D_{\text{fg},n}(R)$ applied to the particle with radius R in the n-th cycle may be expressed as in Equation 17.

[Equation 17]

$$\Delta D_{\mathrm{fg},n}(\mathrm{R}) = \frac{1}{N_{\mathrm{frac},n}(S_n(R))} = \frac{1}{\exp(\beta_0 + \beta_1 \ln(S_n(R) - \sigma_{\lim}))}$$

$$= \frac{1}{\exp\left(\beta_0 + \beta_1 \ln\left(K \cdot \frac{C_{\mathrm{chg}}}{A_{\mathrm{act},n}} \cdot R - \sigma_{\lim}\right)\right)}$$

Accumulated mechanical damage D and particle fracture

Accumulated fatigue damage D that is accumulated on the cathode particle surfaces may be calculated by using the fatigue fracture damage fraction $\Delta D_{\mathrm{fg},n}(R)$ that is calculated by using Equation 17. If the radius R of the cathode particle is defined in $[R_{\min}, R_{\max}]$, that is, if the cathode particle has the radius R not less than the minimum value $R_{\min}$ and not more than the maximum value $R_{\max}$, a total sum $D_n(R)$ of damage accumulated on the cathode particle with radius R by the n-th cycle may be expressed as shown in Equation 19 below. The minimum value $R_{\min}$ and maximum value $R_{\max}$ of the radius R may be obtained from actual experimental (particle analysis) data.

[Equation 19]

$$D_n(R) = \Delta D_{\mathrm{fg},n}(R) + D_{n-1}(R)$$

As the cycle progresses, the damage D continues to accumulate and increases, and if $D_n(R)$ exceeds a damage threshold, a fatigue fracture occurs, that is, a crack generates in the surface of the particle. In such a state, a particle isolation occurs in the particles so that the particles no longer participate in the deintercalation and intercalation processes, and thus, the AML occurs. In addition, the lithium contained in the isolated particles is deactivated (or amount of activated lithium is decreased) and the LIL occurs.

In order to describe the variation of $D_n(R)$ according to the change of cycle, a probability density function G(R) may be defined first as representing distribution of the number of cathode particles according to the radius R. In general, the cathode material includes cathode particles having different radii that are not equal to one another. In the ISIF model, the probability density function G(R) may be derived from an analysis of the actual particle distribution, or by using a probability density function P that follows a normal distribution N as shown in Equation 20 below. In the specification, it is assumed that the cathode particle distribution follows a probability density function P(R).

[Equation 20]

$$P(R) = \mathcal{N}(R; m, \gamma^2)$$

In Equation 20, m denotes an average radius of cathode particles and $\gamma$ denotes a standard deviation of the radii of the cathode particles.

G(R) may be expressed by Equation 21 below.

[Equation 21]

$$G(R) = \frac{P(R)}{\int_{R_{\min}}^{R_{\max}} P(r)dr}$$

In Equation 21, $R_{\max}$ and $R_{\min}$ are respectively a maximum radius and a minimum radius of the cathode particles.

A value obtained by integrating G(R) over the entire section (that is, section between $R_{min}$ and $R_{max}$) is 1. In an embodiment, a minimum radius of the cathode particles in which a fatigue fracture may occur due to the accumulated damage may be calculated.

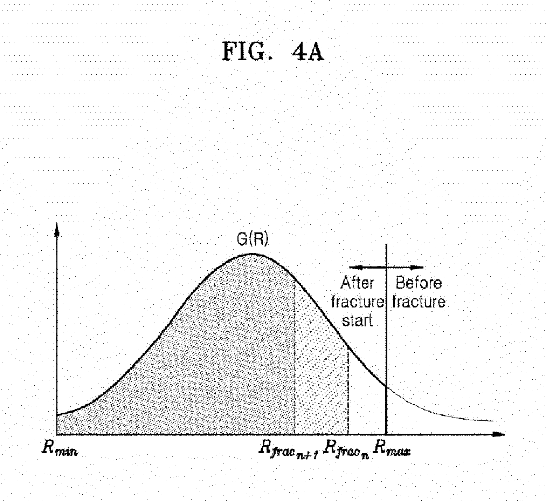

FIG. 4A illustrates an example G(R).

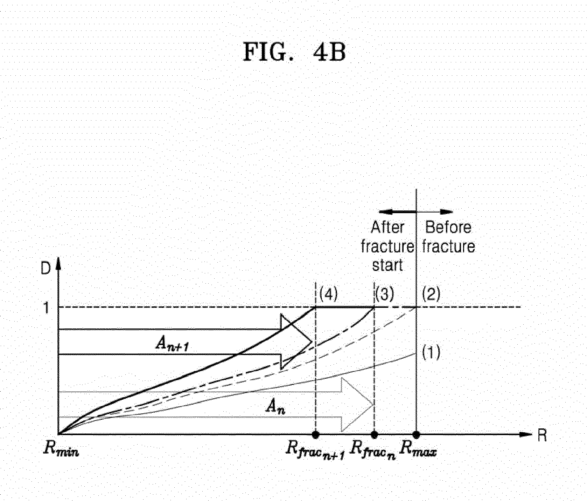

FIG. 4B shows a change in $D_n(R)$ according to the cycles progress, and a change in a total surface area $A_{act,n}$ of cathode active particles in an n-th cycle therefrom. In FIG. 4B, in the state of (1), $D_n(R)$ has a value less than 1 for all radii R within [$R_{min}$, $R_{max}$]. In this case, no fatigue fracture has occurred in any of the cathode particles, and the active particle area $A_{act,n}$ is equal to the total sum of the surface areas of the cathode particles. As the cycle progresses, damage accumulates on each particle, and thus, fatigue fracture of the cathode particles occurs starting from (2) where $D_n(R)$ initially becomes 1 for a radius R defined by [$R_{min}$, $R_{max}$]. As the damage continues to accumulate as the cycle progresses, $D_n(R)$ changes as shown in (3) and (4), and accordingly the radius $R_{th,n}$ of the smallest cathode particle where fatigue fracture occurs in the n-th cycle and the total surface area $A_{act,n}$ of the cathode active particles may be updated every cycle as shown in Equation 22 below.

[Equation 22]

$$R_{\text{th},n} = \min\left\{\underset{R}{\operatorname{argmax}}\, D_n(R)\right\}$$

$$A_{\text{act},n} = n_{\text{total}} \int_{R_{\min}}^{R_{\text{th},n}} 4\pi r^2 G(r)\, dr$$

In Equation 22, R is $R \in [R_{min}, R_{max}]$ and $n_{total}$ is the total number of cathode particles.

If $D_n(R) < 1$ for all R, then $R_{th,n} = R_{max}$, as shown in (1) in FIG. 4B. As shown in (3) and (4) of FIG. 4B, if there are a plurality of radii R satisfying $Dn(R)=1$, the smallest radius R would be $R_{th,n}$.

The total sum $D_n(R)$ of damage accumulated on the cathode particles having the radius R by the n-th cycle may be expressed as follows.

[Equation 23]

$$D_n(R) = \Delta D_{\text{fg},n}(R) + D_{n-1}(R)$$

$$= \cfrac{1}{\exp\left(\beta_0 + \beta_1\, ln\left(K' \cdot \cfrac{C_{\text{chg}}}{\int_{R_{\min}}^{R_{\text{th},n}} 4\pi r^2 G(r)\, dr} \cdot R - \sigma_{\lim}\right)\right)} + D_{n-1}(R)$$

In Equation 23, $K' = K/n_{total}$.

$Dn(R)$ is updated every cycle by using Equation 23 above, and $R_{th,n}$ may be calculated. A decrease amount $\Delta V_{frac,n}$ in the active particle volume due to the fatigue fracture between the (n-1)-th cycle and n-th cycle may be calculated by using $R_{th,n}$ according to Equation 24 below.

[Equation 24]

$$\Delta V_{\text{frac},n} = \frac{\int_{R_{\text{th},n-1}}^{R_{\text{th},n}} r^3 \cdot G(R|m, \gamma^2)\, dr}{\int_{R_{\min}}^{R_{\max}} r^3 \cdot G(R|m, \gamma^2)\, dr}$$

The capacity loss $\Delta RCL_n^+$ due to the fatigue fracture in the cathode particles may be calculated as the product of the decrease amount $\Delta V_{\text{frac,n}}$ in the active particle volume in the corresponding cycle and a ratio of the charges inside the cathode in the corresponding cycle, i.e., $(1 - \overline{SOC_n})$. Here, $\overline{SOC_n}$ denotes an average SOC of the battery during the n-th cycle. For example, if the DOD in the n-th cycle is 100%, $\overline{SOC_n} = 1/2 = 0.5$, and if the SOC is charged and discharged in a section between 10% and 90% in the n-th cycle, $\overline{SOC_n} = (0.1 + 0.9)/2 = 0.5$. Because the SOC is a value in proportion to the amount of charges in the cathode particle, if the average SOC is $\overline{SOC_n}$ in the n-th cycle, the average amount of charges in the cathode particle is proportional to $(1 - \overline{SOC_n})$. As a result, the change in RCL ($\Delta RCL_n^{+}$) caused by AML and LIL due to the fatigue fracture in the cathode in the n-th cycle may be expressed by Equation 25 below.

[Equation 25]

$$\Delta RCL_n^{+} = \Delta V_{\text{frac},n} \cdot \left(1 - \overline{SOC_n}\right)$$

$$= \frac{\int_{R_{\text{th},n-1}}^{R_{\text{th},n}} r^3 \cdot G(r|m, \gamma^2)\, dr}{\int_{R_{\min}}^{R_{\max}} r^3 \cdot G(r|m, \gamma^2)\, dr} \left(1 - \overline{SOC_n}\right)$$

ISIF model - $\Delta RCL^{-}$

The capacity loss amount $\Delta RCL^{-}$ due to LIL in the cathode may be calculated based on an aging density function model (ADFM) disclosed in Korean Laid-open Patent No. 10-2020-0140093.

In the ADFM, it is assumed a total amount of degradation for a certain time period may be expressed as an integral of the aging density for the corresponding time period. Here, the aging density denotes a relative capacity that changes per unit time, and the value of the aging density is defined as a value determined by an aging cycle condition (ACC) that is the charging/discharging cycle characteristic affecting the degradation pattern of the battery. In the ADFM, the current C-rate, the SOC, and rest time $t_{\text{rest}}$ is used as the ACC. A function representing the aging density according to the ACC is an aging density function (ADF) and may be defined by Equation 26 below.

[Equation 26]

$$ADF\left(C\text{-}rate, SOC(t) \,\middle|\, \epsilon\right) = \left(\partial RCL(t)\right)/\partial t$$

In Equation 26, it is assumed that the C-rate has a consistent value over the entire time.

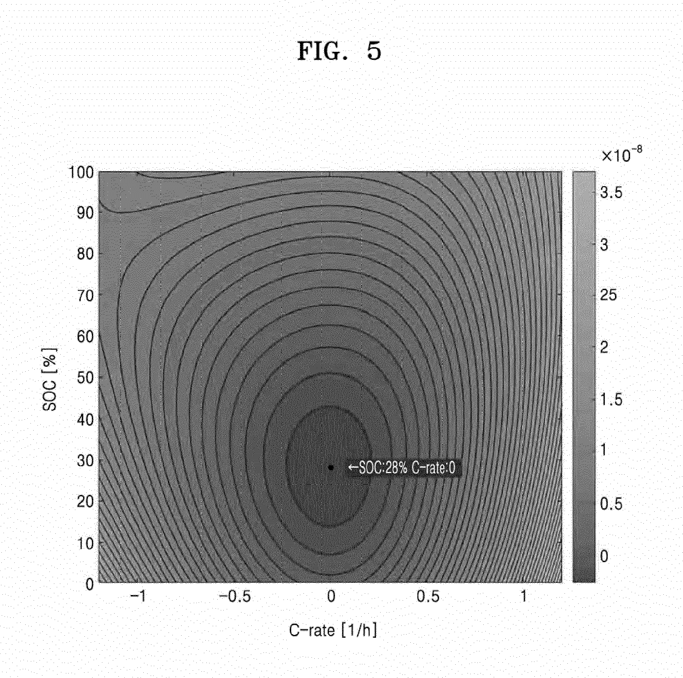

FIG. 5 shows visualization of the ADF. Here, it is assumed that the ADF is an n-th order polynomial in the disclosure. If the ADF is a third-order polynomial, the ADF may be expressed as Equation 27 below.

[Equation 27]

$$ADF(x) = \sum_{m=1, (i,j,k) \in CR(3,3)}^{_3H_3} \alpha_{3,m} x_i x_j x_k$$

$$+ \sum_{m=1, (i,j) \in CR(3,2)}^{_3H_2} \alpha_{2,m} x_i x_j + \sum_{m=1, (i,j) \in CR(3,1)}^{_3H_1} \alpha_{1,m} x_i \cdots + \cdots \alpha_0$$

In Equation 27, x=[C-rate, SOC, $t_{rest}$].

CR(m,n) denotes a set of combinations (redundant combinations) capable of extracting n redundant numbers from the natural number 1, 2, 3, ..., m, and the number of elements in the set is $_mH_n=_{m+n-1}C_n$. For example, CR(3,3) = {(1,1,2), (2,2,2), (1,3,3), (1,1,1),....}, which is a set with a total of $_3H_3=_5C_3$=10 elements. In order to apply the ADF to the charging/discharging cycle, it is assumed that one cycle including 'CC charge $\Rightarrow$ CV charge $\Rightarrow$ rest $\Rightarrow$ CC discharge $\Rightarrow$ rest' is a cycle including 'CC charge for reaching $SOC_{max}$ with a cut-off voltage at constant C-rate' $\Rightarrow$ rest $\Rightarrow$ 'CC discharge for reaching $SOC_{min}$ with a cut-off voltage at constant C-rate' $\Rightarrow$ rest. Also, the capacity value of a certain cycle, which is used to calculate the capacity variation in the certain cycle is assumed to be a constant during the corresponding cycle.

Equation 27 above may be a function of the cycle conditions Q=(C-rate 1, C-rate 2, Cut-off voltage 1, Cut-off voltage 2, Rest time) and the parameters of the ADF $\varepsilon=(\alpha_0, \alpha_{1,1\sim1,3H1}, \alpha_{2,1\sim2,3H2}, \alpha_{3,1\sim3,3H3})$.

The minimum SOC value and the maximum SOC value of each cycle during the process of deriving Equation 27 above may be obtained by mapping two kinds of cut-off voltage values to a lookup table.

The capacity loss amount $\Delta RCL_{chg,n}^{-}$ of the cathode during the charging time in the n-th aging cycle by using the ADF may be expressed as an integral of the ADF from the charging start point in time ($t_{chg,n,start}$) to the end point in time ($t_{chg,n,end}$) during the n-th aging cycle, by Equation 28-1 below.

$$[\text{Equation 28-1}]$$

$$\Delta RCL_{chg,n}^{-} = \int_{t_{chg,n,start}}^{t_{chg,n,end}} ADF(\text{C-rate}, SOC(t)|\epsilon)dt$$

In Equation 28-1, $\varepsilon$ is a model parameter of the ADF and $Cap_{BOL}$ is a capacity value of the battery in its initial state without any charging/discharging cycles.

Likewise, in the n-th aging cycle, the degradation amount $\Delta RCL_{dis,n}^{-}$ during the discharge time and the degradation amount $\Delta RCL_{rest,n}^{-}$ during the rest time may be expressed by Equation 28-2 and Equation 28-3 below.

$$[\text{Equation 28-2}]$$

$$\Delta RCL_{dis,n}^{-} = \int_{t_{dis,n,start}}^{t_{dis,n,end}} ADF(\text{C-rate}, SOC(t)|\epsilon)dt$$

$$[\text{Equation 28-3}]$$

$$\Delta RCL_{rest,n}^{-} = t_{rest}\big(ADF(0, SOC_{max}|\epsilon) + ADF(0, SOC_{min}|\epsilon)\big)$$

The variation amount (increase amount) $\Delta RCL^{-}$ of the RCL by the n-th aging cycle may be calculated by adding Equation 28-1, Equation 28-2, and Equation 28-3 altogether as shown in Equation 29 below.

$$[\text{Equation 29}]$$

$$\Delta RCL_n^{-} = \Delta RCL_{chg,n}^{-} + \Delta RCL_{dis,n}^{-} + \Delta RCL_{rest,n}^{-}$$

ISIF model - total capacity loss amount (RCL) due to degradation at anode and cathode

Finally, at the n-th aging cycle, the total degradation amount $RCL_n$, which is the sum of the degradation amount at the anode and the degradation amount at the cathode, may be calculated recursively for each cycle as shown in Equation 30 below.

[Equation 30]

$$RCL_n = RCL_{n-1} + \Delta RCL_n^- + \Delta RCL_n^+$$

Overall workflow of ISIF model

An example of an algorithm implementing the overall workflow of the ISIF model is as follows.

Estimation of ISIF model parameter and data pre-processing method therefor

---

**Algorithm 1** ISIF Model

---

1: **Input parameters:**
   $C_{min}, C_{max}, R_{min}, R_{max}, m, n_{total}, \gamma$

2: **Tuning parameters:**
   $K, \beta_0, \beta_1, \eta_1, \eta_2, \epsilon = [\epsilon_1, \epsilon_2, \cdots, \epsilon_{30}], c_{s,avg}$

3: **Initialize:**
   $D(R,0), RCL_n \leftarrow 0,$
   $R \leftarrow [R_{min}, R_{max}], \ R_{th,n} \leftarrow R_{max}, \ n \leftarrow 1$

4: **while** $RCL <= 1$ **do**

5: $\quad S_n(R) = K \cdot \frac{C_{chg}}{A_{act,n}} \cdot R$

6: $\quad n_{frac}(S_n(R)) = \exp(\beta_0 + \beta_1 \ln(S_n(R) - \sigma_{lim}))$

7: $\quad \Delta D_{fg,n}(R) = \frac{1}{n_{frac}(S_n(R))}$

8: $\quad R_{th,n} = \min\left\{ \underset{R}{\mathrm{argmax}} D_n(R) \right\}$

9: $\quad A_{act} = n_{total} \int_{R_{min}}^{R_{th,n}} 4\pi r^2 G(r)\, dr, \quad \text{where} \quad G(R) = \frac{P(R)}{\int_{R_{min}}^{R_{max}} P(r)dr}, \quad P(R) = \mathcal{N}(R; m, \gamma)$

10: $\quad D_n(R) = D_{n-1}(R) + \Delta D_{fg,n}(R)$

11: $\quad \Delta V_{frac,n} = \frac{\int_{R_{th,n-1}}^{R_{th,n}} r^3 \cdot G(r|m,\gamma^2) dr}{\int_{R_{min}}^{R_{max}} r^3 \cdot G(r|m,\gamma^2) dr}$

12: $\quad \Delta RCL_n^+ = V_{frac,n} \cdot (1 - \overline{SOC}_n)$

13: $\quad \Delta RCL_{chg,n}^- = \int_{t_{chg,n,start}}^{t_{chg,n,end}} D(C_{chg}, SOC(t)|\epsilon)\, dt, \quad \Delta RCL_{dis,n}^- = \int_{t_{dis,n,start}}^{t_{dis,n,end}} D(C_{dis}, SOC(t)|\epsilon)\, dt,$
   $\quad \Delta RCL_{rest,n}^- = t_{rest} \cdot (D(0, SOC_{max}|\epsilon) + D(0, SOC_{min}|\epsilon))$
   $\quad$ where

14: $\quad \Delta RCL_n^- = \Delta RCL_{chg,n}^- + \Delta RCL_{dis,n}^- + \Delta RCL_{rest,n}^-$

15: $\quad RCL_n \leftarrow RCL_{n-1} + \Delta RCL_n^+ + \Delta RCL_n^-$

16: $\quad n \leftarrow n + 1$

---

If the ISIF model finally receives the charging/discharging cycle conditions (ACC) such as the charging/discharging C-rate and the cut-off upper and lower limit voltages and the number of charging/discharging cycles (n) as inputs, the number of charging/discharging cycles (n) as calculated for RCL may be output. In order to make inputs for the ISIF model, data from battery charging/discharging cycles and RPT experiments may be pre-processed. The data may consist of the cycle conditions and time-serial data according to the conditions. The time-serial data may include the number of charging/discharging cycles performed up to a point where the RPT is performed, and capacity values measured by the RPT in response to the corresponding number of charging/discharging cycles.

In an implementation, first data may include a first cycle condition $ACC_1$ and time-serial data corresponding thereto.

The first cycle condition $ACC_1$ may include C-rate 1=1C, C-rate 2=0.3C, Cut-off voltage 1=3.7V, Cut-off voltage 2=3.3V, Rest time=10min.

First time-serial data corresponding to the first cycle condition ACC1 may be as follows.

| the number of cycles | 0 | ... | 100 | ... | 500 | ... |
|---|---|---|---|---|---|---|
| Capacity (mAh) | 2000 | ... | 1900 | ... | 1300 | ... |

The capacity value may be changed into the RCL value by using the above data.

For example, from the first data, $RCL_1(0)=1-(2000/2000)=0$, $RCL_1(100)=1-(1900/2000)=0.05$, $RCL_1(500)=1-(1300/2000)=0.35$ may be calculated. $RCL_k(N)$ denotes an RCL value in the N-th cycle in k-th data.

A parameter $0^*$ that minimizes an error in a sum of the squares of the capacity loss values may be calculated through a Levenberg-Marquardt algorithm (LMA) according to Equation 31 below.

[Equation 31]

$$\theta^* = \underset{\theta}{\arg\min} \sum_{i=1}^{M} \sum_{j=1}^{N_i} [RCL(j, \theta, ACC_i) - RCL_i(j)]^2$$

In Equation 31, M denotes the number of total pieces of data used to estimate the model parameter, and $N_i$ denotes the number of total sampling points in i-th data. Equation 31 above assumes that the data used in the ISIF model is obtained by measuring the capacity after every cycle. That is, it is assumed that the number of sampling points and the total number of cycles are equal to each other. If the capacity is measured after a plurality of times of cycles are performed, a function c(j) for returning the number of cycles corresponding to the sampling point may be used instead of j.

ISIF+BNN

While the ISIF model may be solely used to predict the degradation pattern of the battery, more accurate degradation pattern may be predicted in combination with a neural network (NN). If a device having a low calculation capability is used, the ISIF may be used alone, and in the case of a device using a processor having a high calculation capability, a higher degradation prediction performance may be obtained by combining the ISIF and the NN.

According to embodiments of the disclosure, not only the prediction of the degradation pattern, but also the accuracy of the prediction, may be identified by using a Bayesian mathematical neural network.

In Equation 31 above, virtual RCL data may be generated by setting various virtual degradation cycle conditions in the ISIF model that may be made by using the parameter $0^*$ value that may be found through the LMA, and then, the virtual RCL data may be designated as training data along with experimental data to train the BNN. Because the influence of the experimental data on the training may be greatly reduced due to too much virtual data, the experimental data and the virtual data may participate in the training in equal proportions. For example, if the number of pieces of the virtual data is 10,000 and the number of pieces of the experimental data is 10, the number differs by 1000 times. Thus, in an implementation, one piece of experimental data is allowed to participate in the training 1000 times whenever one piece of virtual data is allowed to participate in the training once.

According to embodiments, the BNN may be a sparse variational BNN proposed by Molchanov. The sparse variational BNN has advantages in that a learning speed is faster and a generalization performance is higher as compared with existing BNN.

Various embodiments described herein are exemplary and are not intended to be embodied independently from one another. The embodiments described herein may be embodied in combination with one another.

The scope of the disclosure is defined by the following claims rather than by the detailed description of the embodiment of the disclosure. It shall be understood that all modifications and embodiments of the disclosure conceived from the meaning and scope of the claims and their equivalents are included in the scope of the disclosure.

The battery capacity variation prediction model of the disclosure is a hybrid model that combines an empirical model with a physical-based model, and thus, shortcomings of the empirical model and the physical-based model may be complemented.

Because the existing method based on the physical-based model has to solve various complex partial differential equations, a long operation time and high-specification hardware are necessary, and thereby degrade or reduce practicality. On the other hand, the battery capacity variation prediction algorithm according to the disclosure may be calculated with a relatively simple formula having no differential equation, and thus, has low burden of calculation amount and may be practically used in actual devices. In addition, existing empirical models have the issues that there is no standardized model and it is difficult to reflect the characteristics of various types of batteries, but the battery capacity variation prediction model according to embodiments may be applied to various types of batteries by reflecting fatigue fracture that is a physical phenomenon that occurs universally in various types of batteries.

According to embodiments of the battery capacity variation prediction method of the present disclosure, the degradation of the cathode is modeled through empirical principles, and the degradation of the anode is modeled based on physical phenomenon. As such, unlike the existing empirical model, various kinds of batteries may be modeled, and key elements that affect the degradation may be modeled. Thus, the number of parameters is less, and less operation load is obtained as compared with existing physical-based models. Therefore, the battery capacity variation prediction method according to embodiments of the disclosure may be carried out by a computing device having at least one processor and a memory.

While existing models predict degradation only up to the EOL that is a point in time at which the initial capacity has been reduced to 80%, the battery capacity variation prediction model of embodiments of the disclosure may predict capacity variation to 80% or less of the initial capacity, that is, within the entire life span of the battery, including the degradation pattern in the latter part of the battery life span. Moreover, the battery capacity variation model of the disclosure may predict the expression of a knee point that occurs in the latter part of the battery life span. As such, the battery capacity variation prediction method according to the disclosure may be effectively utilized in the process of verifying the continued secondary use of the battery.

Also, the capacity variation prediction method based on the data according to the related art requires a great amount of data. Moreover, a significant amount of resources in terms of time and costs is required to acquire the great amount of data, and in particular, it takes a long time to obtain related data over the entire life span covered by the disclosure. Thus, it is difficult to use the data-based capacity variation prediction method from a practical standpoint. According to the battery capacity variation prediction algorithm of embodiments of the disclosure, the number of parameters that may need to be optimized is significantly less than that of the parameters used in the data-driven model and the physical-based model. Thus, the battery capacity variation may be predicted with significantly less data as compared with the existing methods.

In addition, the battery capacity variation prediction method of embodiments of the disclosure may utilize the BNN to determine reliability of a current predicted value, as well as the predicted value. In addition, information about how much aging occurs under different aging conditions may be obtained, and the obtained information may be used to help design the optimal operating profile to maximize life span.

Also, according to the battery capacity variation prediction algorithm of the disclosure, cost of a battery evaluation test may be reduced. In general, because customers and users have a need to be informed of how the aging is progressing while repeating the charging/discharging cycles under the conditions requested by the customers, actual experiments have to be performed under the corresponding conditions, and the experiment result has to be reported. However, by using the battery capacity variation prediction algorithm of the disclosure, aging information of the battery may be provided to the customer by using the data generated according to the battery capacity variation prediction algorithm of embodiments of the disclosure, even if the actual experiments are not performed under the corresponding conditions.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated.

**Claims**

1. A method of predicting a capacity change of a battery, the method comprising:

    calculating damage to cathode particles of a secondary battery during each charging/discharging cycle if the charging/discharging cycle is repeatedly performed in the secondary battery;
calculating accumulated damage by accumulating the damage;
calculating a minimum radius of the cathode particles in which a fatigue fracture occurs due to the accumulated damage;
calculating, based on a distribution of radii of the cathode particles and the minimum radius, a reduction amount in a volume of a cathode active particle due to the fatigue fracture during each charging/discharging cycle; and
calculating a relative capacity loss at a cathode based on the reduction amount in the volume of the cathode active particle during each charging/discharging cycle.

2. The method as claimed in claim 1, wherein the cathode particles are spherical solid particles, and a lithium concentration is radial symmetry.

3. The method as claimed in claim 1 or 2, wherein the accumulated damage is a fatigue damage D that is accumulated on the cathode particle surfaces.

4. The method as claimed in any of claims 1 to 3, wherein:
the calculating of the damage to the cathode particles during each charging/discharging cycle comprises:

   calculating an effective stress applied to the cathode particles based on a magnitude of a charging current in each charging/discharging cycle;
   calculating a stress range applied to the cathode particles based on the effective stress; and
   calculating the damage corresponding to the stress range, based on a relationship between a magnitude of the stress range and a number of charging/discharging cycles at which the fatigue fracture occurs.

5. The method as claimed in any of claims 1 to 4, wherein the damage of the stress in each charging/discharging cycle contributing to fatigue fracture is calculated by applying Palmgren-Miner's rule.

6. The method as claimed in any of claims 1 to 5, wherein the capacity loss is expressed as a capacity loss relative to an initial capacity $Cap_{BOL}$, RCL,

   wherein RCL is defined by Equation 1,

$$RCL(t) = \frac{Cap_{BOL} - Cap(t)}{Cap_{BOL}}$$

$$RCL_n = \frac{Cap_{BOL} - Cap_n}{Cap_{BOL}}$$

[Equation 1]

   wherein RCL(t) denotes an RCL at a time t, $Cap_{BOL}$ denotes a capacity at the initial state, and Cap(t) denotes a capacity at time t. $RCL_n$ denotes the RCL after n aging cycles are performed from the initial state, and $Cap_n$ denotes a capacity after n aging cycles are performed from the initial state and wherein
   the relative capacity loss $RCL_n$ after performing n aging cycles from the initial state is expressed is expressed as a sum of an RCL after performing (n-1) aging cycles from the initial state, capacity loss $\Delta RCL_n^+$ due to the degradation at the cathode according to the n-th aging cycle, and the capacity loss $\Delta RCL_n^-$ due to the degradation at the negative electrode according to the n-th aging cycle according to Equation 2,

$$RCL_n = RCL_{n-1} + \Delta RCL_n^+ + \Delta RCL_n^-$$

[Equation 2].

7. The method as claimed in any of claims 1 to 6, wherein the stress range S is calculated based on the S-N curve expression proposed by Stromeyer according to Equation 3,

$$n_{\text{frac}}(S) = \exp(\beta_0 + \beta_1 \ln(S - \sigma_{\text{lim}})) \qquad for\ S > \sigma_{\text{lim}},$$

[Equation 3]

wherein $\beta_0$ and $\beta_1$ are preset tuning parameters, and $\overline{\sigma}_{\text{lim}}$ is the minimum value of stress that may cause fatigue fracture.

8.  The method as claimed in any of claims 1 to 7, further comprising:

    calculating a relative capacity loss in an anode during each charging/discharging cycle by using an aging density function (ADF) model; and
    calculating a current state capacity loss of the secondary battery in which a current charging/discharging cycle is performed by adding all of a previous relative capacity loss of the secondary battery calculated in a previous charging/discharging cycle, the relative capacity loss in the cathode, and the relative capacity loss in the anode.

9.  A method of predicting a capacity change of a battery, the method comprising:

    obtaining experimental data by repeatedly performing a charging/discharging cycle of a secondary battery;
    optimizing an inhomogeneous stress-induced fracture, ISIF, model by using the experimental data;
    generating virtual data by using the optimized ISIF model;
    training an artificial neural network by using the experimental data and the virtual data; and
    predicting, by using the artificial neural network, a capacity variation of the secondary battery in which the charging/discharging cycle is repeatedly performed under a preset condition.

10. The method as claimed in claim 9, wherein the artificial neural network is a Bayesian neural network (BNN) using actual data and virtual data.

11. The method as claimed in claim 9 or 10, wherein the charging/discharging cycle of the secondary battery comprises: a constant current charging section in which the secondary battery is charged with a constant current of a charging current value; a constant voltage charging section in which the secondary battery is charged with a constant voltage of a charging voltage value if the charging voltage of the secondary battery reaches a first cut-off voltage; a first rest section in which the charging of the secondary battery is stopped for a first rest time if the charging current of the secondary battery reaches a cut-off current; a constant current discharge section in which the secondary battery is discharged with a constant current of a discharge current value; and a second rest section in which the discharging of the secondary battery is stopped during a second rest time if the discharge voltage of the secondary battery reaches a second cut-off voltage.

12. The method as claimed in any of claims 9 to 11, wherein the obtaining of the experimental data comprises repeatedly performing the charging/discharging cycle on the secondary battery, wherein, in the charging/discharging cycle, at least one the charging current value, the charging voltage value, the discharging current value, the first cut-off voltage, the cut-off current, the second cut-off voltage, the first rest time, and the second rest time is set differently.

# FIG. 1A

FIG. 1B

FIG. 2A

Effective stress

Tensile stress

Compressive stress

Crack propagation

Crack closure

FIG. 2B

FIG. 2C

# FIG. 2D

# FIG. 3A

# FIG. 3B

# FIG. 3C

# FIG. 4A

# FIG. 4B

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020200140093